(19) Europäisches Patentamt
European Patent Office
Office européen des brevets

(11) Veröffentlichungsnummer: **0 048 913**
**B1**

(12) # EUROPÄISCHE PATENTSCHRIFT

(45) Veröffentlichungstag der Patentschrift: **29.01.86**

(51) Int. Cl.⁴: **C 08 G 18/67**, G 03 F 7/10, C 08 F 299/06, C 08 F 283/00

(21) Anmeldenummer: **81107452.5**

(22) Anmeldetag: **19.09.81**

(54) **Gummielastische, ethylenisch ungesättigte Polyurethane enthaltendes durch Strahlung polymerisierbares Gemisch.**

(30) Priorität: **29.09.80 DE 3036694**

(43) Veröffentlichungstag der Anmeldung: **07.04.82 Patentblatt 82/14**

(45) Bekanntmachung des Hinweises auf die Patenterteilung: **29.01.86 Patentblatt 86/5**

(84) Benannte Vertragsstaaten: **AT BE CH DE FR GB IT LI NL SE**

(56) Entgegenhaltungen:
**EP - A - 0 033 897**
**DE - A - 2 937 266**
**FR - A - 2 208 930**
**US - A - 3 658 531**
**US - A - 3 836 492**
**US - A - 3 856 757**

(73) Patentinhaber: **HOECHST AKTIENGESELLSCHAFT, Postfach 80 03 20, D-6230 Frankfurt am Main 80 (DE)**

(72) Erfinder: **Herwig, Walter, Dr., Hasenpfad 7, D-6232 Bad Soden 2 (DE)**
Erfinder: **Erbes, Kurt, Friedrich-Stolz-Strasse 3, D-6093 Flörsheim (DE)**
Erfinder: **Decker, Rudolf, Wormser Strasse 10, D-6501 Bodenheim (DE)**
Erfinder: **Sikora, Helga, Bunsenstrasse 6 F, D-6200 Wiesbaden (DE)**

EP 0 048 913 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Polymere, deren gummielastisches Verhalten nicht auf einer chemischen Vernetzung linearer hochpolymerer Moleküle beruht, sondern durch eine physikalische Wechselwirkung bestimmter Molekülglieder bewirkt wird, sind bekannt.

Als derartige Elastomere haben insbesondere Polyurethane Bedeutung erlangt, die Polyether- oder Polyesterblöcke enthalten. So werden in der FR-A 2 324 666 Polyetherurethane beschrieben, die Einheiten aus Polyetherdiolen, bestimmten niedermolekularen Diolen und aromatischen Diisocyanaten enthalten. In der FR-A 2 313 410 sind Urethangruppen enthaltende Polyetherester beschrieben, die Einheiten aus Polyethylenadipat, Butandiol-1,4 und aromatischen Diisocyanaten enthalten. Polymere dieser Art sind normalerweise Vernetzungsreaktionen nicht mehr zugänglich.

Aus der DE-A 2 937 266 sind photohärtbare Überzugsmassen für Baumaterialien bekannt, die photopolymerisierbare (Meth)acrylsäureester, Ketonharze und Photoinitiatoren enthalten. Die photopolymerisierbaren Verbindungen sind Umsetzungsprodukte von (Meth)acrylsäureestern von Epoxyverbindungen mit Polyisocyanaten. Die Massen eignen sich besonders zur Herstellung von wetterfesten Überzügen. Sie enthalten weniger als ein Drittel ihrer Menge an Ketonharz und sind normalerweise ohne Lösungsmittelzusatz flüssig und daher nicht zur Herstellung lagerfähiger lichtempfindlicher Aufzeichnungsmaterialien geeignet.

Aus der US-A 3 836 492 sind polymerisierbare Überzugsmassen bekannt, die Umsetzungsprodukte aus (Meth)acrylsäure und Dicarbonsäurediglycidylestern, weiter umgesetzt mit Diisocyanaten, sowie gegebenenfalls Photoinitiatoren enthalten. Sie enthalten keine polymeren Bindemittel und sind deshalb mehr oder weniger viskose Produkte.

Polyurethane ähnlicher Struktur werden auch zur Herstellung von photopolymerisierbaren Aufzeichnungsmaterialien, z. B. für Druckplatten und Photoresists, verwendet. Diese Polyurethane haben zumeist den Charakter viskoser bis hochviskoser Flüssigkeiten oder von Feststoffen. Sie werden normalerweise im Gemisch mit anderen Komponenten verwendet.

Diese Gemische enthalten als wesentliche Bestandteile eine radikalisch polymerisierbare Verbindung mit endständigen ethylenisch ungesättigten Gruppen, ein Bindemittel und einen durch Strahlung aktivierbaren Initiator.

Derartige polymerisierbare Gemische sind z. B. aus den US-Patentschriften 2 760 863, 3 060 023 und 3 149 975 bekannt. Als polymerisierbare ethylenisch ungesättigte Verbindungen werden dort niedermolekulare und hochmolekulare Verbindungen mit endständigen bzw. seitenständigen Vinyl- oder Vinylidengruppen, insbesondere Acryl- und Methacrylsäureester von niedermolekularen oder hochmolekularen Polyhydroxyverbindungen, beschrieben. In der Praxis haben sich bisher fast ausschliesslich photopolymerisierbare Materialien auf der Basis solcher Ester als polymerisierbare Verbindungen durchgesetzt. Von diesen sind es insbesondere die niedermolekularen Vertreter, die in der Technik bevorzugt eingesetzt werden.

Solche Gemische werden in der Reproduktionstechnik zur Herstellung von Druckplatten, Photoresists, d. h. Ätz- und Galvanoreservagen, und – ggf. farbigen – Reliefbildern verwendet.

Eine besondere Gruppe derartiger Gemische, die zur Photoresistherstellung dienen, wird als trockene photopolymerisierbare Schicht auf einem temporären Schichtträger aus einer transparenten flexiblen Kunststoffolie verwendet, wobei die Schicht unter Druck und Erwärmen auf einen bildmässig zu modifizierenden Träger aus Metall, z. B. eine Kupferplatte, laminiert, dort belichtet und zum Photoresist entwickelt wird. Solche Materialien und Verarbeitungsverfahren sind z. B. in der DE-B 1 522 515 und der DE-A 2 064 079 beschrieben.

Als polymerisierbare Verbindungen werden in derartigen Gemischen häufig Urethangruppen enthaltende Verbindungen mit endständigen Acryl- oder Methacrylsäureestergruppen verwendet, die noch Oligoethereinheiten enthalten können. Gemische mit solchen oligomeren polymerisierbaren Verbindungen, die meist eine besonders gute Flexibilität aufweisen, sind z. B. in den DE-A 2 822 189, 2 822 190 und 2 822 191, der DE-B 2 115 373 und den US-A 3 850 770 und 3 960 572 beschrieben.

Oligourethanverbindungen des hier beschriebenen Typs sind auch zur Herstellung von synthetischen Elastomeren mit vorteilhaften Eigenschaften bekannt, wie es z. B. aus der GB-A 1 441 108 bekannt ist.

Aufgabe der Erfindung war es, durch Strahlung polymerisierbare Gemische vorzuschlagen, die sich durch eine gute Flexibilität im unvernetzten und vernetzten Zustand auszeichnen und zugleich im unvernetzten Zustand einen sehr geringen kalten Fluss aufweisen.

Erfindungsgemäss wird ein durch Strahlung polymerisierbares Gemisch vorgeschlagen, das als wesentliche Bestandteile 40 bis 70 Gew.-% eines in wässrig-alkalischen Lösungen löslichen Bindemittels, eine zur Einleitung der strahlungsinitiierten radikalischen Polymerisation ausreichende Menge eines durch Strahlung aktivierbaren Polymerisationsinitiators und 30 bis 60 Gew.-% an polymerisierbaren Acryl- oder Methacrylsäureestern enthält, und das dadurch gekennzeichnet ist, dass 10 bis 60 Gew.-% der Menge der Ester aus einer Verbindung der allgemeinen Formel I

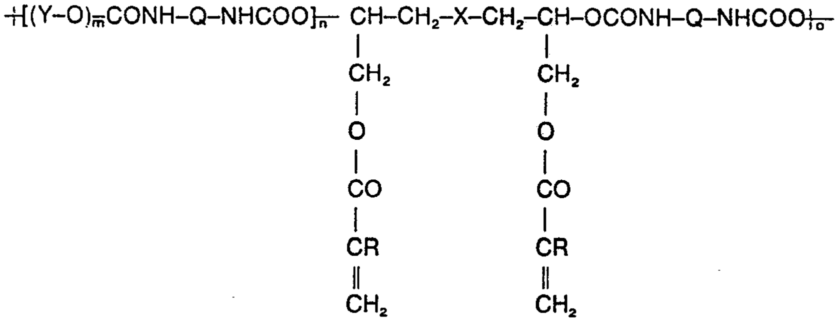

I

bestehen, worin

Q ein zweiwertiger ein- oder zweikerniger aromatischer Rest, der unsubstituiert oder durch niedere Alkylgruppen substituiert ist und der als Bindeglied eine niedere Alkylengruppe enthalten kann,

X eine der Gruppen

$-O-Ph-Z-Ph-O-$ und

$-OOC-(CH_2)_y-COO-$,

wobei Ph eine gegebenenfalls substituierte Phenylengruppe, Z eine Alkylengruppe mit 1–4 Kohlenstoffatomen und y eine Zahl von 2 bis 12 ist,

R ein Wasserstoffatom oder eine Methylgruppe,

Y ein Alkylenrest mit 2 bis 6 Kohlenstoffatomen,

m eine Zahl von 4 bis 50,

n eine Zahl von 1 bis 6 und

o eine Zahl von 4 bis 20 ist,

und dass der Rest der polymerisierbaren Ester aus niedermolekularen Acryl- oder Methacrylsäureestern von zwei- oder mehrwertigen Alkoholen besteht.

Die Polyetheresterurethane der Formel I sind gummielastische lineare Polymere, die in zahlreichen organischen Solventien löslich und mit vielen niedermolekularen di- und polyfunktionellen Acryl- und Methacrylsäureestern in weitem Verhältnis mischbar sind. Sie bilden mit zahlreichen polymeren Bindemitteln einheitliche Phasen und sind somit in besonderem Masse zur Herstellung homogener lichtempfindlicher negativ arbeitender Schichten geeignet. Überraschend ist, dass diese elastischen polymeren Urethane, die für sich allein in wässrigen Alkalien nicht dispergierbar sind, in Kombination mit bestimmten Acrylaten und polymeren Bindemitteln Schichten ergeben, die mit rein wässrigen, lösungsmittelfreien oder überwiegend lösungsmittelfreien Entwicklern entwickelt werden können.

Die hohe Elastizität und Flexibilität der polymeren Urethane erlaubt es ferner, Schichten herzustellen, die sich, vor allem auch im belichteten Zustand, durch gute Zähigkeit und Abriebfestigkeit auszeichnen, eine Eigenschaft, die sich bei trockenen und flüssigen Resisten, bei trockenen und flüssigen Lötstopmasken und bei Druckplatten nutzen lässt. Ein weiterer Vorteil ist, dass sich das rheologische Verhalten solcher Schichten speziellen technologischen Erfordernissen in besonderem Masse anpassen lässt. Beispielsweise gelingt es bei einem zur Rollenware verarbeiteten Trockenresist, die so sehr gefürchtete Randverklebung an den Schnittkanten auch bei Warmlagerung praktisch zu unterbinden.

Die Herstellung dieser Polyetheresterurethane mit ethylenisch ungesättigten Seitengruppen erfolgt in bekannter Weise durch Umsetzen von oligomeren Diisocyanaten mit bestimmten Hydroxyalkylacrylaten oder -methacrylaten.

Die Ausgangskomponenten sind:

A. Flüssige bis zähflüssige oligomere, lineare Etherurethane mit Isocyanatendgruppen der allgemeinen Formel II

$$OCN-Q-NHCOO-[-(-Y-O)_m-CONH-Q-NHCOO-]_{n-1}-(Y-O)_m-CONH-Q-NCO \qquad II$$

worin die Symbole Q, m, n und Y die oben angegebene Bedeutung haben. Diese oligomeren handelsüblichen Etherurethane werden nach bekannten Verfahren hergestellt durch Umsetzung von Polyetherdiolen mit Tolylendiisocyanaten im molaren Überschuss. Man erhält dadurch ein Gemisch von homologen Oligomeren mit Isocyanatendgruppen. Wird dabei der molare Überschuss so gewählt, dass der Mittelwert von n im Bereich von 1 bis 4 liegt, erhält man Harze mit zähflüssiger Konsistenz.

B. Bis-acrylsäureester-diole der allgemeinen Formel III

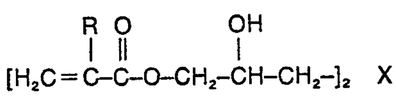

III

worin X und R die oben angegebene Bedeutung haben.

Durch Polyaddition der Komponenten A und B erhält man die elastischen Polyurethane.

Durch intermolekulare Polymerisation der Acrylatgruppen lassen sich die Eigenschaften der Polymeren variieren und vor allem deren Gummielastizität erheblich verbessern.

Die Polyadditionen werden nach bekannten Verfahren durchgeführt. Man kann die Umsetzungen in unpolaren und polaren Lösemitteln durchführen, z. B. in Toluol, Aceton, Ethylmethylketon, Tetrahydrofuran. Zur Beschleunigung der Reaktion können die Reaktionsmedien erhitzt werden, ferner empfiehlt sich die Verwendung eines Katalysators, z. B. von Zinn-II-laurat oder einem Metallchelat, wie Eisentrisacetylacetonat. Nach erfolgter Polyaddition lassen sich die Polymeren durch Entfernen – z. B. durch Destillation oder Gefriertrocknung – des Lösemittels isolieren, gegebenenfalls können sie aber auch durch Einrühren der Reaktionsansätze in andere flüssige Medien, z. B. Methanol, gefällt und abfiltriert werden. Man kann die Polyadditionen auch lösemittelfrei durchführen, indem man die Komponenten, gegebenenfalls unter Zusatz von Katalysatoren, in passenden Mischern, z. B. Nockenknetern, innig vermengt und dabei gegebenenfalls erwärmt.

In allen Fällen werden lineare unvernetzte Polyurethane erhalten, die noch die oben erwähnten Acrylatgruppen enthalten. Diese Polymeren besitzen gummielastische Eigenschaften und sind thermoplastisch.

Die Molekulargewichte der Polyurethane können je nach Anwendungszweck in weiten Bereichen variieren. Im allgemeinen werden vorteilhafte Produkte erhalten, wenn die reduzierten spezifischen Viskositäten (RSV), gemessen an 1%igen Lösungen in Dimethylformamid bei 25 °C, bei etwa 0,15 bis 1,4 dl/g liegen. Bevorzugt werden Produkte mit RSV-Werten im Bereich von 0,2 bis 0,9 dl/g.

Bevorzugte mittlere Werte von m liegen bei 8–20, von n bei 2–4, von o bei 5–12 und von y bei 2–6.

Q ist eine ein- oder zweikernige Arylengruppe, die im allgemeinen 6 bis 20 Kohlenstoffatome hat. Die aromatischen Kerne können durch niedere Alkylgruppen mit 1 bis etwa 4 Kohlenstoffatomen substituiert sein. Wenn zwei aromatische Kerne vorliegen, können diese miteinander kondensiert, durch eine einfache Valenz oder über eine Alkylengruppe mit 1 bis 4 Kohlenstoffatomen verbunden sein. Beispiele für geeignete Arylengruppen sind Phenylen-, Tolylen-, Xylylen-, Naphthylen-, Diphenylen-, methyl- und ethylsubstituierte Diphenylengruppen, Diphenylmethan- und 2,2-Diphenylpropangruppen mit freien Valenzen in der 2-, 3- oder 4-Stellung der beiden Kerne, vorzugsweise in 4,4'-Stellung.

Y ist eine lineare oder verzweigte Alkylengruppe. Bevorzugte Vertreter sind Ethylen-, 1,2-Propylen- und 1,4-Butylengruppen.

Z ist eine Alkylengruppe, in der die freien Valenzen bevorzugt an einem C-Atom stehen. Bevorzugte Gruppen sind Methylen-, 1,1-Ethylen- und 2,2-Propylengruppen.

Die mit Z verbundenen Phenylengruppen können z. B. durch Alkylgruppen mit 1–4 C-Atomen, Alkoxygruppen mit 1–4 C-Atomen oder Halogenatome substituiert sein. Wegen der leichten Zugänglichkeit werden Verbindungen mit unsubstituierten Phenylengruppen bevorzugt. R ist vorzugsweise eine Methylgruppe.

Die ungesättigten Polyurethane werden, wie bereits erwähnt, als photoreaktive Verbindungen in photopolymerisierbaren bzw. durch Strahlung polymerisierbaren Gemischen verwendet. Sie werden dort mit einem durch Strahlung, insbesondere durch Licht, aktivierbaren Initiator, einem polymeren, normalerweise gesättigten Bindemittel und zur Verbesserung der Lichtempfindlichkeit und gegebenenfalls der Entwickelbarkeit der Schicht mit wässrigen Lösungen mit anderen, niedermolekularen Acryl- bzw. Methacrylsäureestern kombiniert.

Das polymerisierbare Gemisch enthält im allgemeinen 20 bis 100, vorzugsweise 30 bis 60 Gew.-% an polymerisierbaren bzw. vernetzbaren Verbindungen und 0 bis 80, vorzugsweise 40 bis 70 Gew.-% Bindemittel. Von den polymerisierbaren Verbindungen können wiederum 5 bis 100, vorzugsweise 10 bis 60 Gew.-% aus Urethanen der Formel I bestehen.

Als niedermolekulare Acryl- bzw. Methacrylsäureester kommen in Betracht die Ester dieser Säuren mit zwei- oder mehrwertigen Alkoholen, z. B. Ethylenglykol, Diethylenglykol, Triethylenglykol, Polyethylenglykole mit Molekulargewichten von 200 bis 1000, Butandiol-1,4, Neopentylglykol, Trimethylolethan oder -propan, 1,3-Butandiol und Bisphenol A-bishydroxyethylether. Es sind ferner die niedermolekularen, Urethangruppen enthaltenden Bis-acrylate und Bis-methacrylate geeignet, die durch Umsetzen von 2 Mol Hydroxyalkylacrylat oder -methacrylat mit 1 Mol eines aliphatischen oder cycloaliphatischen Diisocyanats, z. B. 2,2,4-Trimethyl-hexamethylendiisocyanat, erhalten werden.

Die erfindungsgemässen Gemische enthalten ferner Bindemittel, die in wässrig-alkalischen Lösungen löslich oder mindestens quellbar sind, da sich Schichten mit solchen Bindemitteln mit den bevorzugten wässrig-alkalischen Entwicklern entwickeln lassen. Derartige Bindemittel können z. B. die folgenden Gruppen enthalten: $-COOH$, $-PO_3H_2$, $-SO_3H$, $-SO_2NH_2$, $-SO_2NH-CO-$. Als Beispiele hierfür seien genannt: Maleinatharze, Polymerisate aus

N-(p-Tolylsulfonyl)-carbaminsäure-(β-methacryloyloxyethyl)-ester

und Mischpolymerisate dieser und ähnlicher Monomerer mit anderen Monomeren, Styrol-Maleinsäureanhydrid-Mischpolymerisate und Methylmethacrylat-Methacrylsäure-Mischpolymerisate.

Besonders vorteilhaft sind Mischpolymerisate aus Methacrylsäure, Alkylmethacrylaten und Methylmethacrylat und/oder Styrol, Acrylnitril u. a. wie sie in den DE-OS 2 064 080 und 2 363 806 beschrieben sind. Auch Styrol-Maleinsäureanhydrid- oder Styrol-Maleinsäureester-Mischpolymerisate können mit Erfolg eingesetzt werden.

Als Photoinitiatoren in dem erfindungsgemässen Gemisch können eine Vielzahl von Substanzen Verwendung finden. Beispiele sind Benzoin, Alkylbenzoine, Benzoinether, Mehrkernchinone, z. B.
2-Ethyl-anthrachinon, Acridinderivate, z. B.
9-Phenyl-acridin, 9-p-Methoxy-phenylacridin,
9-Acetylamino-acridin, Benz(a)acridin;
Phenazinderivate, z. B.
9,10-Dimethylbenz(a)phenazin,
9-Methyl-benz(a)phenazin,
10-Methoxy-benz(a)-phenazin,
Chinoxalinderivate,
z. B. 6,4',4''-Trimethoxy-2,3-diphenylchinoxalin,
4',4''-Dimethoxy-2,3-diphenyl-5-azachinoxalin
oder Chinazolinderivate.

Die erfindungsgemässen Gemische können ausser Monomeren, Bindemitteln und Fotoinitiatoren noch eine Reihe weiterer üblicher Zusätze enthalten, z. B. Inhibitoren zur Verhinderung der thermischen Polymerisation der Monomeren, Wasserstoffdonatoren, sensitometrische Regler, Farbstoffe, Farbpigmente, ungefärbte Pigmente, Farbbildner, Indikatoren und Weichmacher.

Diese Bestandteile sind zweckmässig so auszuwählen, dass sie in dem für den Initiierungsvorgang wichtigen aktinischen Wellenlängenbereich möglichst nicht zu stark absorbieren.

Als aktinische Strahlung soll jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Das erfindungsgemässe photopolymerisierbare Gemisch kann in bekannter Weise gelöst in Lösemitteln oder Lösemittelgemischen in den Handel gebracht werden und vom Verbraucher vielfältig eingesetzt werden, z. B. zur Herstellung von Galvanoresisten, Ätzschutzschichten, speziellen Schablonen für den Siebdruck, Lötstopmasken. Ferner lassen sich die erfindungsgemässen Gemische zur Herstellung von Trockenresistfolien verwenden. Diese bestehen aus einer auf einem temporären Träger, z. B. einer transparenten Kunststoff-Folie befindlichen fertigen Photoresistschicht, die vom Verbraucher auf die bildmässig zu ätzende oder zu galvanisierende Unterlage laminiert und dort belichtet und entwickelt wird, wobei vor dem Entwickeln der temporäre Träger entfernt wird.

Das erfindungsgemässe Gemisch eignet sich besonders gut für diese Anwendungsform. Es kann aber auch in Form eines vorsensibilisierten Kopiermaterials auf einem geeigneten Träger, z. B. auf Aluminium oder Zink, für die photomechanische Herstellung von Offset- oder Hochdruckformen, z. B. Flexodruckformen, fabrikmässig hergestellt werden. Es ist ferner zur Herstellung von Reliefbildern, Siebdruckschablonen, Farbprüffolien und dergl. geeignet. Seine Vorteile kommen in allen den Fällen zur Geltung, wo es auf gute und dauerhafte Flexibilität und Elastizität der belichteten Schicht bei geringem Kaltfluss der unbelichteten Schicht sowie hohe Resistenz der belichteten Schicht gegen aggressive Chemikalien ankommt.

Die Herstellung der lichtempfindlichen Materialien unter Verwendung des erfindungsgemässen Gemisches erfolgt in bekannter Weise. So kann man die Mischung in einem Lösungsmittel aufnehmen und die Lösung bzw. Dispersion durch Giessen, Sprühen, Tauchen, Antragen mit Walzen usw. auf den vorgesehenen Träger als Film aufbringen und anschliessend trocknen. Dicke Schichten (z. B. von 250 µm und darüber) kann man auch durch Extrudieren oder Verpressen als selbsttragende Folie herstellen, welche dann auf den Träger laminiert wird.

Als Träger für die zu Kopierschichten verarbeiteten Gemische kommen Metalle, z. B. Aluminium, Zink, Kupfer, Stahl, Chrom, Messing und andere Metallegierungen; Siebdruckschablonenträger, z. B. aus Nickel oder Perlongaze; und Kunststoffolien in Frage, wobei die Kunststoffolien, z. B. Polyesterfolien, speziell oberflächenbehandelt sein können.

Die Kopierschichten werden in bekannter Weise belichtet und entwickelt. Als Entwickler sind wässrige, vorzugsweise wässrig-alkalische Lösungen, z. B. von Alkaliphosphaten, -carbonaten oder -silikaten, geeignet, denen gegebenenfalls kleine Mengen, z. B. bis zu 10 Gew.-% an wassermischbaren organischen Lösungsmitteln oder auch Netzmitteln zugesetzt werden können. Schichten, deren Anteil an polymerisierbaren Verbindungen überwiegend aus den Polyurethanen der Formel I besteht, erfordern zur Entwicklung einen höheren Anteil an organischem Lösungsmittel. Die Entwicklung kann von Hand oder in handelsüblichen Sprüh- oder Bürstentwicklungsgeräten erfolgen.

Die erfindungsgemässen Gemische lassen sich, wie oben erwähnt, für die verschiedensten Anwendungsgebiete einsetzen. Mit besonderem Vorteil werden sie zur Herstellung von Photoresist- bzw. Ätzschutzschichten auf metallischen Trägern verwendet. Vor allem sind sie zur Anwendung auf Trägern aus Kupfer geeignet. Die ausgezeichnete Haftung und Flexibilität der belichteten Schichtteile bewährt sich bei diesen bevorzugten Anwendungsformen nicht nur während der Entwicklung, sondern auch während einer nachfolgenden Ätzung des Trägers, bei der die Schichten eine gute Flexibilität und Ätzresistenz zeigen.

Die Gemische lassen sich besonders gut in der Form sogenannter Trockenresistmaterialien, wie sie oben erwähnt wurden, einsetzen und handhaben, da sie sich auch trocken zu gut haftenden Schichten auf Metallträger übertragen lassen. In diesem Fall sind als temporäre Trägerfolien besonders Polyesterfolien geeignet.

Die folgenden Beispiele erläutern einzelne Ausführungsformen des erfindungsgemässen Gemischs. Wenn nichts anderes angegeben ist, sind Prozentzahlen und Mengenverhältnisse in Gewichtseinheiten zu verstehen. Gewichtsteile (Gt) und Volumteile (Vt) stehen im Verhältnis von g zu ml.

Beispiel 1

Eine Lösung wurde hergestellt aus:

| | | |
|---|---|---|
| 6,5 | Gt | eines Terpolymerisates aus n-Hexylmethacrylat, Methacrylsäure und Styrol (60:30:10) mit einem mittleren Molgewicht von ca. 35.000 und der Säurezahl 195, |
| 3,2 | Gt | Polyethylenglykol-400-dimethacrylat, |
| 0,8 | Gt | des unten beschriebenen Elastomeren, |
| 0,1 | Gt | 9-Phenyl-acridin, |
| 0,035 | Gt | eines Azofarbstoffs, erhalten durch Kuppeln von 2,4-Dinitro-6-chlor-benzoldiazoniumsalz mit 2-Methoxy-5-acetylamino-N-cyanoethyl-N-hydroxyethylanilin, |
| 2,5 | Gt | Methylethylketon und |
| 3 | Gt | Ethanol. |

Das verwendete Elastomere wurde wie folgt hergestellt:

A. In einem 1-Liter-Vierhalskolben, ausgerüstet mit Rührer, Thermometer, Rückflusskühler und Trockenrohr, wurden 426 Gt Glycidylmethacrylat und 216 Gt Adipinsäure durch Rühren vermischt und nach Zugabe von 19,7 Gt p-Methoxy-phenol und 6,4 Gt Benzyl-triethylammoniumchlorid vorsichtig auf eine Innentemperatur von 80 °C erhitzt. Nach ca. 2 Stunden wurde eine klare Lösung erhalten, die noch 14 Stunden bei 80 °C gehalten wurde. Der Gehalt an freiem Glycidylmethacrylat war nach dieser Zeit kleiner als 0,5%.

B. In einen mit Rührer, Thermometer, Tropftrichter, Kühler und Trockenrohr bestückten 1-Liter-Vierhalskolben wurden 143 Gt eines oligomeren Diisocyanats der oben angegebenen Formel II, wobei Q der Tolylenrest und Y der 1,4-Butylenrest ist, mit einem mittleren Molekulargewicht um 2000 und einem Isocyanatgruppengehalt von 4,1 Gew.-% (Adiprene L 100), gelöst in 300 Vt Methylethylketon, gegeben und mit 0,87 Gt Benzochinon und 0,85 Vt einer Lösung versetzt, die durch Lösen von 6,3 Gt Eisen-III-acetylacetonat und 0,45 Gt Triethylamin in Methylethylketon und Auffüllen mit Methylethylketon auf 100 Vt hergestellt wurde. In den Tropftrichter wurde eine Lösung von 31,33 Gt des nach A erhaltenen Umsetzungsproduktes in 300 Vt Methylethylketon gefüllt und der auf 70 °C erhitzten und gerührten Lösung im Kolben innerhalb 40 Minuten zugetropft. Nach zweistündigem Nachrühren bei 30 °C wurden dem klaren Reaktionsgemisch 10 Vt Ethanol zugesetzt. Durch Abdestillieren des Lösemittels wurde aus der viskosen Lösung eine nicht klebende kautschukartige Masse erhalten, die in zahlreichen organischen Lösungsmitteln, wie Tetrahydrofuran, Aceton oder Toluol klar löslich war. Die reduzierte spezifische Viskosität des Produkts betrug 0,72 dl/g (gemessen an einer 1%igen Lösung in Dimethylformamid bei 25 °C). Diese Beschichtungslösung wurde auf eine biaxial verstreckte und thermofixierte Polyethylenterephthalatfolie der Stärke 25 µm so aufgeschleudert, dass nach dem Trocknen bei 100 °C ein Schichtgewicht von 45 g/m² erhalten wurde.

Die erhaltene Trockenresistfolie wurde mit einer handelsüblichen Laminiervorrichtung bei 120 °C auf eine mit 35 µm starker Kupferfolie kaschierte Phenoplast-Schichtstoffplatte laminiert und 4 Sekunden mit einem handelsüblichen Belichtungsgerät (5 kW Leistung) belichtet. Als Vorlage diente eine Strichvorlage mit Linienbreiten und Abständen bis herab zu 60 µm.

Nach der Belichtung wurde die Polyesterfolie abgezogen und die Schicht in einer 0,8%igen Natriumcarbonatlösung in einem Sprühentwicklungsgerät 60 Sekunden lang entwickelt.

Die Platte wurde 30 Sekunden mit Leitungswasser gespült, 30 Sekunden in einer 15%igen Ammoniumperoxydisulfat-Lösung angeätzt und sodann nacheinander in den folgenden Elektrolytbädern galvanisiert:

1. 40 Minuten in einem Kupferelektrolytbad der Firma Schlötter, Geislingen/Steige, Typ «Glanzkupfer-Bad»

| | |
|---|---|
| Stromdichte | 2,5 A/dm² |
| Metallaufbau | ca. 20 µm |

2. 10 Minuten in einem Nickelbad Typ «Norma» der Firma Schlötter, Geislingen/Steige

| | |
|---|---|
| Stromdichte | 5 A/dm² |
| Metallaufbau | 10 µm |

3. 10 Minuten in einem Goldbad Typ «Autronex CC» der Firma Blasberg, Solingen

| | |
|---|---|
| Stromdichte | 1,0 A/dm² |
| Metallaufbau | 2,0 µm. |

Das auf der Platte erzeugte Galvanomuster zeigte an keiner Stelle Unterwanderungen oder Beschädigungen. Diese Platte liess sich in 5%iger KOH-Lösung bei ca. 40–50 °C entschichten. Das auf diese Weise freigelegte Kupfer kann in üblichen Ätzmitteln weggeätzt werden.

Im technischen Massstab wurde dieses Beispiel wie folgt ausgeführt:

Mit einer Lösung der oben angegebenen Zusammensetzung wurde eine 110 cm breite Bahn einer Polyesterfolie mittels einer Schlitzdüse kontinuierlich beschichtet. Nach Durchlaufen einer Trockenzone hatte die Resistschicht eine Dicke von 38 µm und wurde mit einer Polypropylenfolie abgedeckt. Die so gefertigte Trockenresistfolie wurde auf einer Grossrolle gespeichert. Die Grossrolle wurde anschliessend mittels eines Rollenschneiders zu handlichen Resistrollen einer Breite von 45 cm und einer Bahnlänge von 50 m zerschnitten. Durch Einstellen einer optimalen Wickelspannung wurde gewährleistet, dass die Rolle Lage für Lage gleichmässig über dem Trägerkern aufgebaut sass und seitlich nicht abrutscht, d. h. nicht teleskopierte. So hergestellte Rollen wurden in einem Trockenschrank bei 40 °C gelagert.

Selbst nach Lagerzeiten von mehr als 12 Wochen waren die Schnittkanten der Rollen unverändert und völlig frei von zur Verklebung führenden Resistaustritten. Dieser Trockenresist liess sich in gleicher Weise wie oben verarbeiten.

Der oben beschriebene Trockenresist war auch bei 10facher Überbelichtung, also nach 40 Sekunden Belichtung mit dem beschriebenen Belichtungsgerät, sehr elastisch und flexibel. Man kann einen belichteten Resiststreifen z. B. mehrmals bei Raumtemperatur um 180° knicken, ohne dass die Knickstelle reisst. Durch Strecken lässt sich der Resist auf das 3- bis 4fache dehnen. Dieses Verhalten ist z. B. beim manuellen Retuschieren fertiger Leiterplatten wichtig. Ferner sind flexible Resists notwendig zur Herstellung durchkontaktierter Schaltungen («Tenting-Verfahren»).

Die beschriebenen Schichten erlauben es, Linien der Breite 80 µm kantenscharf aufzulösen, die Resistflanken stehen senkrecht auf dem Basiskupfer. Dieses Verhalten wurde durch Belichtung durch eine entsprechende Auflösungstestvorlage und anschliessende Entwicklung mit 0,8%iger Sodalösung nachgewiesen. Die Entwicklerresistenz betrug dabei mindestens das Fünffache der Entwicklungszeit.

Beispiel 2

Die in Beispiel 1 beschriebene Lösung wurde auf eine mit 35 µm starker Kupfer-Folie kaschierte Phenoplastschichtstoffplatte aufgeschleudert in der Weise, dass ein Trockengewicht von 37–38 g/m² erhalten wurde. Anschliessend wurde die Platte im Umlufttrockenschrank 3 Minuten bei 100 °C getrocknet. Die so hergestellte Platte wurde in völliger Analogie zum Beispiel 1 weiterbehandelt, jedoch unter Verwendung einer Strichvorlage mit Linienbreiten und Abständen bis herab zu 5 µm. Bei dieser Belichtung direkt durch die als Belichtungsmaske dienende Strichvorlage ohne PET-Zwischenfolie wurden Galvanobahnen bis zu einer Breite von 25 µm kantenscharf aufgelöst.

Beispiel 3

Es wurde wie in Beispiel 1 gearbeitet, wobei anstelle des dort verwendeten Elastomeren 0,7 Gt des im folgenden beschriebenen Produkts verwendet wurden:

177 Gt des in Beispiel 1 unter B angegebenen Diisocyanats wurden in 250 Vt Methylethylketon unter Zugabe von 1 Gt 1,4-Benzochinon, 0,05 Gt Eisen-III-acetylacetonat und 2 Vt einer 1%igen Lösung von Triethylamin in Methylethylketon in einem 1-Liter-Dreihalskolben, versehen mit Thermometer, Tropftrichter, Kühler, Trockenrohr und Magnetrührer, vorgelegt.

Zu dieser Lösung wurde nach Erhitzen auf 60 °C eine Lösung von 45,3 Gt
2,2-Bis[4-(2-hydroxy-3-methacryloyloxy-propoxy)-phenyl]-propan,
Handelsprodukt, (C theor.: 67,97%; C gef.: 67,9%; H theor.: 7,03; H gef.: 7,1; OH-Zahl theor.: 219; OH-Zahl gef.: 216; Br-Zahl theor.: 62,5; Br-Zahl gef.: 65) in 150 Vt Methylethylketon innerhalb von 30 Minuten zugetropft und das Reaktionsprodukt 2 Stunden bei 65–70 °C gehalten; danach wurden 5 Vt Alkohol zugesetzt. Durch Abdestillieren des Lösemittels wurde ein trockener, elastischer Kautschuk, rücklöslich in Methylethylketon und anderen organischen Lösemitteln, wie Toluol und Tetrahydrofuran, erhalten. Das Produkt hatte eine reduzierte spezifische Viskosität von 0,68 dl/g (gemessen an einer 1%igen Lösung von Dimethylformamid bei 25 °C).

In völliger Analogie zum Beispiel 1 wurde eine Trockenresistfolie hergestellt, diese laminiert, belichtet und entwickelt. Weder bei diesen Schritten, noch den folgenden Galvanisierungen ergaben sich wesentliche Unterschiede zu den Ergebnissen des Beispiels 1.

Besonders bemerkenswert war die Kupferhaftung des frisch laminierten noch nicht belichteten Resists. Diese Haftung wurde geprüft analog einer «Gitterschnittprüfung für Anstriche und ähnliche Beschichtungen» nach DIN 53 151. Eine Resistprobe wurde mit einer Rasierklinge sechsmal längs und sechsmal quer eingeschnitten, so dass auf einer Fläche von etwa 1 cm² 25 Vierecke entstanden. Auf diese Fläche wurde ein Stück druckempfindlicher Klebstreifen von 12 mm Breite diagonal über das Ritzmuster geklebt. Der Film wurde dann in einem Winkel von 90° abgezogen. Das untersuchte Material zeigte bereits 30 Sekunden nach dem Laminieren keinerlei Ausrisse.

Beispiele 4 bis 7

In der folgenden Tabelle sind vier Beispiele summiert, die sich in der technischen Durchführung nicht von den Beispielen 1 und 2 unterscheiden, jedoch rezeptuelle Unterschiede besitzen. Dadurch bedingte Eigenschaftsvarianten der Resists sind in der Tabelle stichwortartig notiert. Die Mengen sind in Gewichtsteilen angegeben.

| Beispiel | Bindemittel | Menge | Acrylatmonomeres | Menge | 9-Phenylacridin | Farbstoff von Bsp. 1 | Eigenschaften und Bemerkungen |
|---|---|---|---|---|---|---|---|
| 4 | Terpolymeres aus Butylmethacrylat/ Methacrylsäure/ Styrol (66,7:20:11,3), SZ 122–125 | 6,5 | PEG-400-dimethacrylat | 3,0 | 0,1 | 0,035 | leicht klebrige Schicht, besonders gute Metallhaftung. Gute Goldbadbeständigkeit in Goldbädern mit niedriger Stromausbeute |
| | | | Elastomeres aus Beispiel 1 | 0,6 | | | |
| 5 | wie Beispiel 1 | 6,5 | Bis-urethandimethacrylat*) | 5,0 | 0,1 | 0,035 | Besonders geeignet für Blei-Zinn-Galvanik |
| | | | Elastomeres aus Beispiel 1 | 0,6 | | | |

*) hergestellt aus 1 Mol Trimethylhexamethylendiisocyanat und 2 Mol β-Hydroxyethylmethacrylat

| Beispiel | Bindemittel | Menge | Acrylatmonomeres | Menge | 9-Phenylacridin | Farbstoff von Bsp. 1 | Eigenschaften und Bemerkungen |
|---|---|---|---|---|---|---|---|
| 6 | Copolymeres aus Vinylacetat/Crotonsäure (90:10) SZ 70 | 6,0 | Elastomeres aus Beispiel 1 | 4,0 | 0,2 | 0,025 | entwickelt mit Trichloräthan |
| 7 | Terpolymeres aus Butylmethacrylat/ Methylmethacrylat/ Methacrylsäure (45:35:20) SZ 157 | 6,5 | wie Beispiel 4 | 3,0<br>0,6 | 0,1 | 0,035 | entwickelt mit einer wässrigen 3%igen Lösung von $Na_2SiO_3 \cdot 9H_2O$ |

Beispiel 8

10 Gt des in Beispiel 1 beschriebenen Elastomeren wurden zusammen mit 0,18 Gt 9-Phenyl-acridin und 0,02 Gt des roten Azofarbstoffs der folgenden Struktur

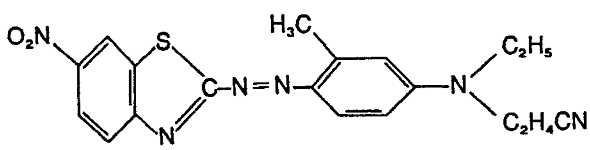

in 35 Vt Methylethylketon gelöst.

Diese Lösung wurde so auf eine 23 µm starke Polyesterfolie aufgeschleudert, dass nach dem Trocknen bei 100 °C ein Schichtgewicht von ca. 50 g/m² erhalten wurde. Diese Trockenresistfolie wurde mit einer handelsüblichen Laminiervorrichtung bei 120 °C auf eine mit 35 µm starker Kupferfolie kaschierte Phenoplast-Schichtstoffplatte laminiert. Nach 90 Sekunden Belichtung mit einem 5 kW-Belichtungsgerät durch eine ein Leiterbild tragende Maske, wurde die Polyesterfolie abgezogen und die Schicht mit Hilfe eines mit 1,1,1-Trichloräthan getränkten Wattetampons entwickelt. Die freigelegte Metallschicht wurde in üblicher Weise galvanisiert und veredelt (vergl. Beispiel 1). Nach dem Galvanisieren liess sich die lichtvernetzte Resistschicht mit wässriger Lauge entfernen und das zu Tage tretende Kupfer in üblichen Ätzmedien wegätzen.

Beispiel 9

Eine adäquate Menge der in Beispiel 1 beschriebenen Beschichtungslösung wurde auf eine auf einem rotierenden Teller liegende Polyesterfolie so aufgegossen (Schleuderbeschichtungsverfahren), dass nach dem Trocknen bei 100 °C eine 50–100 µm dicke Resistschicht erhalten wurde. Der Resist wurde mit einem handelsüblichen Laminator bei 120 °C auf eine mit einer gedruckten Schaltung versehene Phenolharz- oder Epoxid-Leiterplatte laminiert. Anschliessend wurde durch eine Maske, die die zu lötenden Punkte abdeckte, mit einem handelsüblichen Belichtungsgerät mit 5 kW-MH-Lampe belichtet, 2 Minuten in einem handelsüblichen Sprühprocessor mit 0,8%iger Soda-Lösung entwickelt, trokkengeblasen und zwecks Nachhärtung noch 40 Sekunden belichtet. Das Löten der so vorbehandelten Leiterplatten erfolgte in einem handelsüblichen Tauchlötbad, das mit einem eutektischen Sn/Pb-Gemisch (63 Sn/37 Pb) gefüllt war. Vor dem Löten wurde die präparierte Platte mit einer Lösung von Kolophonium in Isopropanol benetzt. Die Eintauchzeit in das 250 °C heisse Lötbad betrug 10 Sekunden. Die resistfreien, zu lötenden Stellen zeigten einwandfreien Lötaufbau. Die gehärtete Resistschicht überstand die Temperaturbelastung der Lötoperation ohne Veränderung.

Beispiel 10

Eine Trockenresistfolie wurde wie in Beispiel 8 hergestellt, jedoch wurden anstelle von 10 Gt des Elastomeren 8 Gt Elastomeres und 2 Gt Polyethylenglykol-400-diacrylat verwendet. Die Verarbeitung erfolgte wie in Beispiel 8 beschrieben mit der Ausnahme, dass die Belichtungszeit 8 Sekunden betrug. Es wurden ähnlich gute Ergebnisse erhalten.

**Patentanspruch**

Durch Strahlung polymerisierbares Gemisch, das als wesentliche Bestandteile 40 bis 70 Gew.-% eines in wässrig-alkalischen Lösungen löslichen Bindemittels, eine zur Einleitung der strahlungsinitiierten radikalischen Polymerisation ausreichende Menge eines durch Strahlung aktivierbaren Polymerisationsinitiators und 30 bis 60 Gew.-% an polymerisierbaren Acryl- oder Methacrylsäureestern enthält, dadurch gekennzeichnet, dass 10 bis 60 Gew.-% der Menge der Ester aus einer Verbindung der allgemeinen Formel I

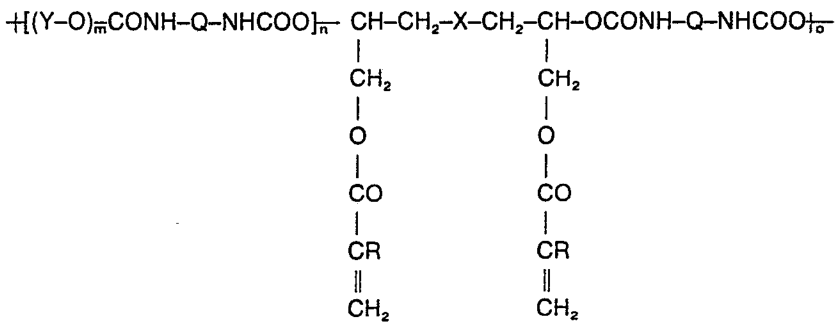

I

bestehen, worin

Q ein zweiwertiger ein- oder zweikerniger aromatischer Rest, der unsubstituiert oder durch niedere Alkylgruppen substituiert ist und der als Bindeglied eine niedere Alkylengruppe enthalten kann,

X eine der Gruppen

$-O-Ph-Z-Ph-O-$ und

$-OOC-(CH_2)_y-COO-$,

wobei Ph eine gegebenenfalls substituierte Phenylengruppe, Z eine Alkylengruppe mit 1–4 Kohlenstoffatomen und y eine Zahl von 2 bis 12 ist,

R ein Wasserstoffatom oder eine Methylgruppe,

Y ein Alkylenrest mit 2 bis 6 Kohlenstoffatomen,

m eine Zahl von 4 bis 50,

n eine Zahl von 1 bis 6 und

o eine Zahl von 4 bis 20 ist,

und dass der Rest der polymerisierbaren Ester aus niedermolekularen Acryl- oder Methacrylsäureestern von zwei- oder mehrwertigen Alkoholen besteht.

**Claim**

A mixture which can be polymerized by radiation and which contains, as essential constituents, 40 to 70% by weight of a binder which is soluble in aqueous-alkaline solutions, a polymerization initiator which can be activated by radiation, in an amount sufficient to initiate a radiation-initiated free radical polymerization and 30 to 60% by weight of a polymerizable acrylic or methacrylic acid ester, characterized in that from 10 to 60% by weight of the amount of the ester correspond to a compound of the general formula I

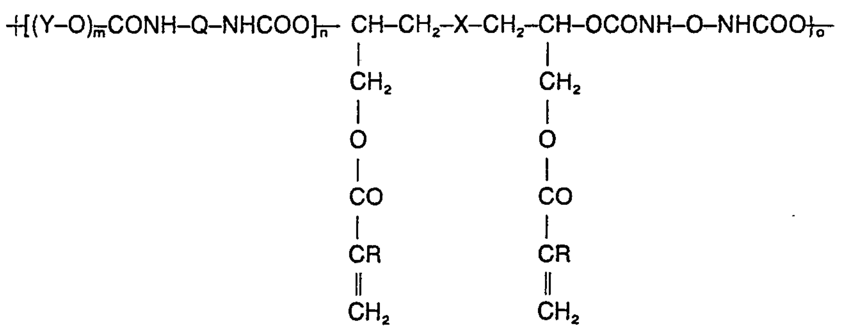

I

wherein

Q is a divalent, mononuclear or dinuclear aromatic radical which is unsubstituted or is substituted by lower alkyl groups and which can contain, as a linking member, a lower alkylene group,

X is one of the groups

$-O-Ph-Z-Ph-O-$ and

$-OOC-(CH_2)_y-COO-$,

Ph being an optionally substituted phenylene group, Z being an alkylene group having 1–4 carbon atoms and y being a number from 2 to 12,

R is a hydrogen atom or a methyl group,

Y is an alkylene radical having 2–6 carbon atoms,

m is a number from 4 to 50,

n is a number from 1 to 6 and

o is a number from 4 to 20,

the remainder of the polymerizable esters being low molecular weight acrylic or methacrylic acid esters of di- or polyhydric alcohols.

**Revendication**

Mélange polymérisable par irradiation qui contient comme constituants essentiels 40 à 70% en poids d'un liant soluble dans des solutions aqueuses alcalines, une quantité d'un amorceur de polymérisation activable par irradiation, suffisante pour le déclenchement de la polymérisation radicalaire amorcée par irradiation, et 30 à 60% en poids d'esters d'acide acrylique ou méthacrylique polymérisables, caractérisé par le fait que 10 à 60% en poids de la quantité des esters consistent en un composé de formule générale I

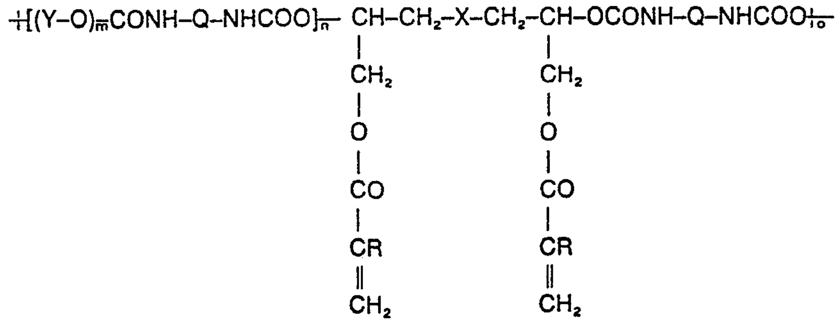

I

dans laquelle

Q est un radical aromatique bivalent à un ou deux noyaux, qui n'est pas substitué ou qui est substitué par des groupes alkyle inférieurs et qui peut contenir en tant que chaînon de liaison un groupe alkylène inférieur,

X est un des groupements
$-O-Ph-Z-Ph-O-$ et
$-OOC-(CH_2)_y-COO-$,
Ph étant un groupe phénylène éventuellement substitué, Z étant un groupe alkylène contenant 1–4 atomes de carbone et y étant un nombre allant de 2 à 12,

R est un atome d'hydrogène ou un groupe méthyle,

Y est un radical alkylène ayant de 2 à 6 atomes de carbone,

m est un nombre allant de 4 à 50,

n est un nombre allant de 1 à 6 et

o est un nombre allant de 4 à 20,

et que le reste des esters polymérisables consiste en des acrylates ou méthacrylates d'alcools bi- ou polyvalents, de faible poids moléculaire.